# EUROPEAN PATENT APPLICATION

(11) **EP 4 451 332 A2**
(43) Date of publication of application: **23.10.2024**
(21) Application number: 24167206.2
(22) Date of filing: 28.03.2024
(51) Int. Cl.: H01L 27/02, G11C 17/12, H01L 23/528, H10B 20/00

(54) **INTEGRATED CIRCUIT INCLUDING READ ONLY MEMORY (ROM) CELL**

(30) Priority: 17.04.2023 KR 20230050255; 12.06.2023 KR 20230075067
(71) Applicant: Samsung Electronics Co., Ltd., Suwon-si, Gyeonggi-do 16677 (KR)
(72) Inventor: YOUN, Suk, 16677 Suwon-si, Gyeonggi-do (KR); KIM, Taehyung, 16677 Suwon-si, Gyeonggi-do (KR); TANG, Hoyoung, 16677 Suwon-si, Gyeonggi-do (KR)
(74) Representative: Kuhnen & Wacker Patent- und Rechtsanwaltsbüro PartG mbB

(57) **Abstract**

An integrated circuit includes a read only memory (ROM) cell which includes an on-cell. The on-cell includes: a first source/drain region and a second source/drain region; a frontside contact between the first source/drain region and a bit line on a front side of the on-cell; and a backside contact between the second source/drain region and a power line on a back side of the on-cell. The bit line is configured to provide a bit line signal to the on-cell, and the power line is configured to provide a power supply voltage signal to the on-cell. The bit line and the power line are vertically aligned with each other.

## Description

### CROSS-REFERENCE TO RELATED APPLICATION

This application is based on and claims priority under 35 U.S.C. §119 to Korean Patent Application No. 10-2023-0050255, filed on April 17, 2023, and Korean Patent Application No. 10-2023-0075067, filed on June 12, 2023, in the Korean Intellectual Property Office, the disclosures of which are incorporated by reference herein in their entirety.

### BACKGROUND

Embodiments of the disclosure relate to an integrated circuit, and more particularly, to an integrated circuit including read only memory (ROM) cells.

Recently, as down-scaling of a semiconductor device rapidly progresses, a high density of integration and a low power consumption rate of the semiconductor device are required. Also, as the size of the semiconductor device is reduced, the area of a standard cell is decreased and the width of a pattern connecting standard cells to each other is decreased. Therefore, efficient arrangement and interconnection of standard cells are required, and research is being conducted on a method of arranging line patterns for supplying power or signals to the standard cells.

### SUMMARY

The disclosure provides an integrated circuit including read only memory (ROM) cells with a reduced area.

The technical problems of the present invention are not limited to the above-mentioned contents, and other technical problems not mentioned will be clearly understood by a person skilled in the art from the following description.

According to an aspect of the disclosure, there is provided an integrated circuit including a ROM cell including an on-cell. The on-cell may include: a first source/drain region and a second source/drain region; a frontside contact between the first source/drain region and a bit line on a front side of the on-cell; and a backside contact between the second source/drain region and a power line on a back side of the on-cell. The bit line may be configured to provide a bit line signal to the on-cell, and the power line may be configured to provide a power supply voltage signal to the on-cell. The bit line and the power line may be vertically aligned with each other.

According to an aspect of the disclosure, there is provided an integrated circuit which may include: a plurality of ROM cells, a plurality of bit lines configured to provide bit line signals to the plurality of ROM cells, a plurality of word lines configured to provide word line signals to the plurality of ROM cells, and a plurality of power lines configured to provide a power supply voltage to the plurality of ROM cells. The plurality of bit lines and the plurality of power may be aligned with each other in a vertical direction.

According to an aspect of the disclosure, there is provided an integrated circuit including a ROM cell including an on-cell. The on-cell may include: a first source/drain region and a second source/drain region; a backside contact between a bit line in a backside metal layer on a back side of the ROM cell and the first source/drain region; and a frontside contact between a power line in a metal layer on a front side of the ROM cell and the second source/drain region. The bit line may be configured to provide a bit line signal to the on-cell. The power line may be configured to provide a power supply voltage signal to the on-cell. The bit line and the power line are aligned with each other in a vertical direction.

### BRIEF DESCRIPTION OF DRAWINGS

Example embodiments of the disclosure will be more clearly understood from the following detailed description taken in conjunction with the accompanying drawings in which:
FIG. 1A is an equivalent circuit diagram of a read only memory (ROM) cell storing data "0", and FIG. 1B is an equivalent circuit diagram of a ROM cell storing data "1";
FIGS. 2A and 2B are layout views for explaining on-cells among ROM cells included in an integrated circuit, according to an embodiment;
FIGS. 3A and 3B are cross-sectional views taken along line Y1-Y2 of FIG. 2A;
FIGS. 4 and 6 are layout views for explaining off-cells among ROM cells included in an integrated circuit, according to an embodiment;
FIG. 5 is a cross-sectional view taken along line Y3-Y4 of FIG. 4, and FIG. 7 is a cross-sectional view taken along line Y5-Y6 of FIG. 6;
FIG. 8 is a view for explaining an integrated circuit, according to an embodiment;
FIGS. 9A through 9C are cross-sectional views taken along lines Y7-Y8, Y9-Y10, and Y11-Y12 of FIG. 8, respectively;
FIG. 10 is a view for explaining an integrated circuit, according to an embodiment;
FIG. 11 is a view for explaining an integrated circuit, according to an embodiment;
FIG. 12 is a cross-sectional view taken along line Y13-Y14 of FIG. 11;
FIG. 13 is a flowchart of a method of manufacturing an integrated circuit, according to an embodiment;
FIG. 14 is a block diagram of a system on chip, according to an embodiment; and
FIG. 15 is a block diagram of a computing system including a memory that stores a program, according to an embodiment.

### DETAILED DESCRIPTION

The embodiments described herein are non-limiting example embodiments, and thus, the disclosure is not limited thereto and may be realized in various other forms. Each of the embodiments provided in the above description is not excluded from being associated with one or more features of another example or another embodiment also provided herein or not provided herein but consistent with the disclosure.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

As used herein, an expression "at least one of" preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c. Herein, when a term "same" or "equal" is used to compare a dimension of two or more elements, the term may cover a "substantially same" or "substantially equal" dimension.

Hereinafter, embodiments of the disclosure will be described more fully with reference to the accompanying drawings. In the accompanying drawings, like reference numerals may refer to like elements, and repeated descriptions of the like elements will be omitted.

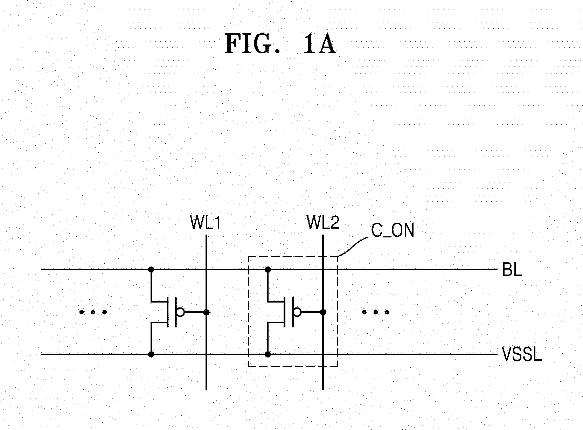

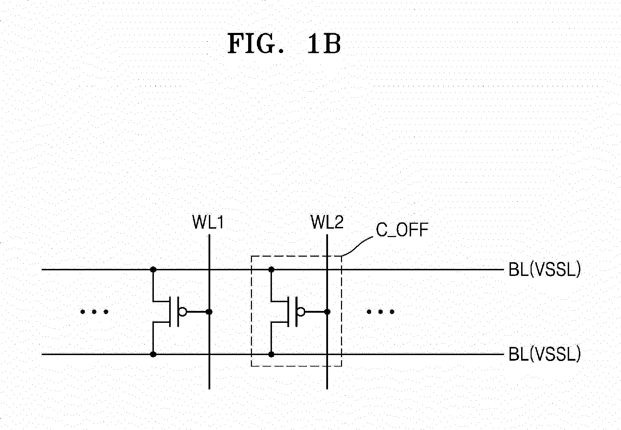

FIG. 1A is an equivalent circuit diagram of a read only memory (ROM) cell storing data "0", and FIG. 1B is an equivalent circuit diagram of a ROM cell storing data "1".

The ROM is a non-volatile memory that can only be read, and data stored in a cell of the ROM is fixed according to a user's request in a manufacturing process of the ROM. A ROM cell in which a ROM is implemented may be formed of one transistor, for example, a P-type transistor, and may be coded as data "0" or data "1" according to a connection between the ROM cell and a bit line or a power line. For example, data to be stored in the ROM cell is fixed according to a user's request in a manufacturing process.

Depending on how the ROM cell is connected to the bit line, the ROM cell may be classified as a diffusion ROM (DROM) cell, a via ROM (VROM) cell, or the like. For example, in the case of a VROM cell, an electrical connection between a memory cell and a bit line may be determined according to presence or absence of a contact or a via which may be formed through a contact or a via process.

Referring to FIG. 1A, an on-cell C_ON, which is a ROM cell storing data "0", may be connected to a bit line BL and a power line VSSL, and may include one transistor of which a gate is connected to a word line (e.g., WL1, WL2, ...). The power line VSSL may provide a power supply voltage (e.g., VSS or ground voltage) to the ROM cell. When the on-cell C_ON is selected through the word lines WL1, WL2, ..., the bit line BL is discharged by the on-cell C_ON, and thus, data stored in the ROM cell can be data "0".

Referring to FIG. 1B, an off-cell C_OFF, which is a ROM cell storing data "1", may be connected to bit lines BL, and may include one transistor of which a gate is connected to a word line (e.g., WL1, WL2, ...). Alternatively, the off-cell C_OFF may be connected to power lines VSSL, and may include one transistor of which a gate is connected to a word line (e.g., WL1, WL2, ...). Even when the off-cell C_OFF is selected through the word line WL1, WL2, ..., the bit line BL is not discharged by the off-cell C_OFF, and thus, data stored in the ROM cell can be data "1".

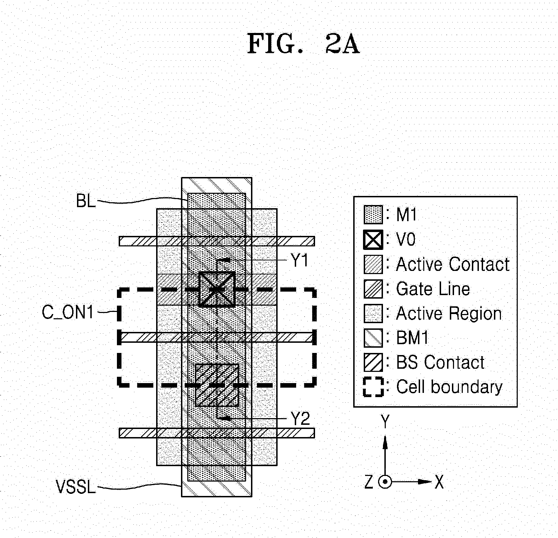

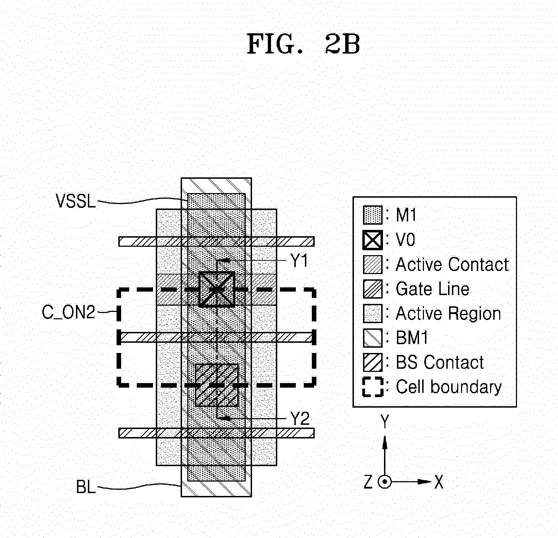

FIGS. 2A and 2B are layout views for explaining on-cells C_ON1 and C_ON2 among ROM cells included in an integrated circuit according to an embodiment.

FIGS. 2A and 2B are plan views illustrating an on-cell C_ON1, which is a ROM cell included in an integrated circuit, on a plane formed by an X axis and a Y axis. In this specification, an X-axis direction and a Y-axis direction may be referred to as a first horizontal direction and a second horizontal direction, respectively, and a Z-axis direction may be referred to as a vertical direction with respect to a substrate SUB. A plane made up of an X-axis and a Y-axis may be referred to as a horizontal plane, a component arranged in a + Z-axis direction relative to another component may be referred to as being on or above the other component, and a component arranged in a -Z-axis direction relative to another component may be referred to as being under or below the other component.

The integrated circuit may include metal layers on which wires connected to standard cells including ROM cells are formed. For example, the integrated circuit may include one or more frontside metal layers stacked at a front side of a cell architecture formed of a plurality of standard cells or a semiconductor device including or formed based on the cell architecture. For example, the front side of the cell architecture or the semiconductor device may be a side or region vertically above an upper surface of a substrate. Further, the integrated circuit may include one or more backside metal layers stacked at a back side of the cell architecture or the semiconductor device. For example, the back side of the cell architecture or the semiconductor device may be a side or region below the upper surface of the substrate.

The frontside metal layers may include a first metal layer M1 formed closest to the substrate. According to an embodiment, the first metal layer M1 may include patterns each extending in the Y-axis direction. The frontside metal layers may include at least one additional metal layer stacked above the first metal layer M1.

The backside metal layers may include a first backside metal layer BM1 formed closest to the substrate. According to an embodiment, the backside metal layer BM1 may include patterns each extending in the Y-axis direction. The backside metal layers may further include at least one additional backside metal layer stacked below the first backside metal layer BM1.

Patterns formed in each of the frontside metal layers and the backside metal layers may include metal, conductive metal nitride, metal silicide, or a combination thereof. In the drawings of this specification, only some layers may be shown for convenience of illustration, and, in order to indicate a connection between a pattern of a metal layer and a pattern of an underlying metal layer, at least one via and/or contact may be shown even when they are formed below the pattern of the metal layer.

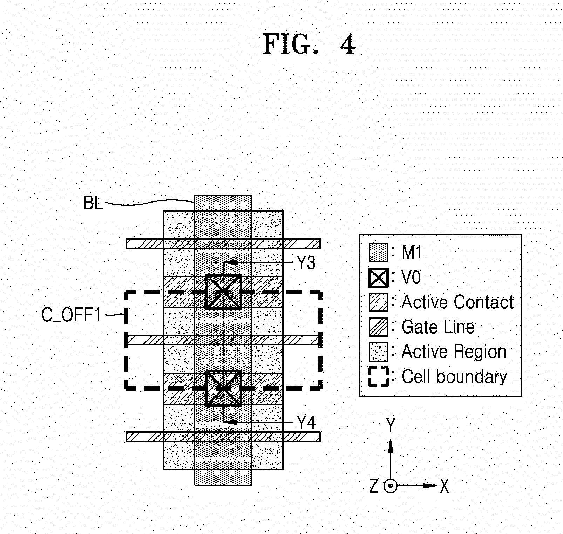

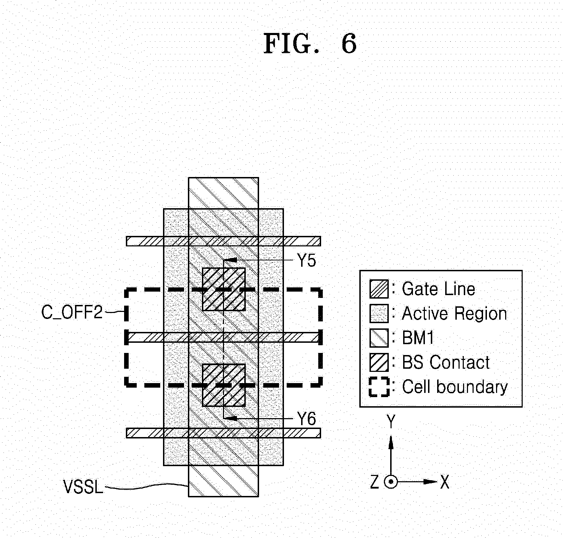

A ROM cell including the on cell C_ON1 and an off cell (e.g., C_OFF1 in FIG. 4 and C_OFF2 in FIG. 6) may include an active region and a gate line. The active region and the gate line included in the ROM cell may form a transistor. The gate line may extend in the X-axis direction, and the active region may extend in the Y-axis direction. The active region may be referred to as a p-channel field effect transistor (PFET) region.

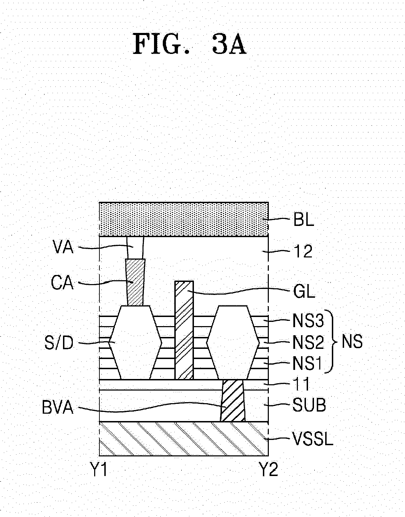

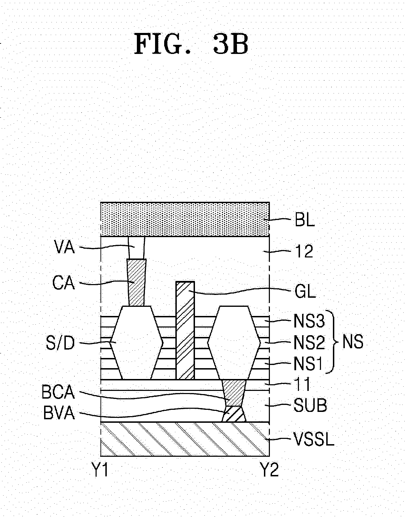

Portions of the active region each protruding in the +Z-axis direction and each extending in the Y-axis direction may form a transistor with a gate line, and may be referred to as an active pattern. Source/drain regions may be respectively formed at both sides of the gate line, an active contact, which is a frontside (FS) contact, may be formed on at least one of the source/drain regions, and a channel surrounded by the gate line may be formed between the source/drain regions. Examples of the channel will be described later with reference to FIGS. 3A and 3B. A via of a first via layer V0 may be disposed on the FS contact, and the via of the first via layer V0 may be connected to the FS contact and the pattern of the first metal layer M1.

Referring to FIG. 2A, the on-cell C_ON1 defined by a cell boundary may include a gate line and an active region that form a P-type transistor. The on-cell C_ON1 may include an active contact (e.g., CA of FIG. 3A) and a via (e.g., VA of FIG. 3A) of the first via layer V0 both connected to the bit line BL formed in the first metal layer M1. The on-cell C_ON1 may include a backside (BS) contact connected to a power line VSSL formed in the first backside metal layer BM1.

The on-cell C_ON1 may also include a bit line BL and a power line VSSL to be connected thereto. For example, the on-cell C_ON1 may include a pattern in one first metal layer M1 and a pattern in one first backside metal layer BM1. These patterns may each be a metal pattern. According to an embodiment, the bit line BL and the power line VSSL connected to the on-cell C_ON1 may overlap each other in the Z-axis direction, and may be aligned in the Z-axis direction. Further, the bit line BL and the power line VSSL may be extended in the second horizontal direction. According to an embodiment, a width of the power line VSSL formed in the first backside metal layer BM1 may be greater than that of the bit line BL formed in the first metal layer M1. However, embodiments are not limited thereto.

Referring to FIG. 2B, the on-cell C_ON2 defined by a cell boundary may include a gate line and an active region that form a P-type transistor. The on-cell C_ON2 may include an active contact and a via of the first via layer V0 both connected to the power line VSSL formed in the first metal layer M1. The on-cell C_ON2 may include a backside (BS) contact connected to a bit line BL formed in the first backside metal layer BM1.

The on-cell C_ON2 may also include a bit line BL and a power line VSSL to be connected thereto. According to an embodiment, the bit line BL and the power line VSSL connected to the on-cell C_ON2 may overlap each other in the Z-axis direction, and may be aligned in the Z-axis direction. According to an embodiment, a width of the bit line BL formed in the first backside metal layer BM1 may be greater than that of the power line VSSL formed in the first metal layer M1. However, embodiments are not limited thereto.

Accordingly, in the on-cells C_ON1 and C_ON2 according to the disclosure of FIGS. 2A and 2B, one of the bit line BL and the power line VSSL is formed in the first metal layer M1, which is a frontside metal layer, and the other one is formed in the first backside metal layer BM1, which is a backside metal layer. Thus, compared to a comparative example in which the bit line BL and the power line VSSL are both formed in frontside metal layers, an area occupied by the on-cells C_ON1 and C_ON2 may be reduced. Thus, a degree of integration of an integrated circuit including the on-cells C_ON1 and C_ON2 may increase and the area of the integrated circuit may decrease.

Because the bit line BL or the power line VSSL is formed by a backside wiring pattern of the first backside metal layer BM1, and the on-cells C_ON1 and C_ON2 directly receive a supply voltage or signal through the backside wiring pattern, IR drop characteristics of supply voltages or signals provided to the on-cells C_ON1 and C_ON2 may be improved.

In the on-cells C_ON1 and C_ON2 according to the disclosure, one of the bit line BL and the power line VSSL is formed in the first metal layer M1, which is a frontside metal layer, and the other one is formed in the first backside metal layer BM1, which is a backside metal layer, and thus, restrictions on the widths of the on-cells C_ON1 and C_ON2 in the X-axis direction are reduced so that the widths of the on-cells C_ON1 and C_ON2 in the X-axis direction may be adjusted. Accordingly, respective widths of the active regions of the on-cells C_ON1 and C_ON2 in the X-axis direction may be adjusted, and respective sizes of the P-type transistors constituting the on-cells C_ON1 and C_ON2 may be adjusted. In addition, respective widths of the bit lines BL connected to the on-cells C_ON1 and C_ON2 in the X-axis direction may be adjusted.

FIGS. 3A and 3B are cross-sectional views taken along line Y1-Y2 of FIG. 2A. Although not shown in FIGS. 3A and 3B, a gate spacer may be formed on a side surface of the gate line GL, and a barrier layer may be formed on a surface of a contact and/or a via.

FIGS. 3A and 3B illustrate an example in which a nanosheet is formed on an active region. Descriptions of FIGS. 3A and 3B will be given in conjunction with FIG. 2A. For example, in a ROM cell including an on cell C_ON1 and an off cell (e.g., C_OFF1 in FIG. 4 and C_OFF2 in FIG. 6), a plurality of nanosheets may be stacked on an active region and a multi-bridge channel (MBC) FET in which a gate line GL surrounds the plurality of nanosheets may be formed. However, the ROM cell included in the integrated circuit according to the disclosure is not limited to that shown in FIGS. 3A and 3B. For example, a fin field-effect transistor (FinFET) including one or more fins and a gate line GL formed on an active region may be formed in the ROM cell, or, for example, a gate-all-around (GAA) FET in which one or more nanowires formed on the active region is surrounded by a gate line GL may be formed. A vertical GAA FET may be formed in which a plurality of nanowires are vertically stacked on an active region and the plurality of nanowires are surrounded by a gate line GL. For example, a negative capacitance (NC) FET may be formed in the active region. In addition to the above-described examples of transistors, various transistors (such as, a complementary FET (CFET), a negative FET (NCFET), a carbon nanotube (CNT) FET, a bipolar junction transistor, and other three-dimensional transistors may be formed on the gate line GL and the active region.

The substrate SUB may include a semiconductor (such as, silicon (Si) or germanium (Ge)), or a Groups III-V element-containing compound (such as, GaAs, AlGaAs, InAs, InGaAs, InSb, GaSb, InGaSb, InP, GaP, InGaP, InN, GaN, or InGaN). According to an embodiment, the substrate SUB may be a silicon-on-insulator (SOI) substrate or a germanium-on-insulator (GOI) substrate. According to an embodiment, the substrate SUB may be doped with P-type impurities.

An active region may be formed in the substrate SUB. The active region may be formed in an N-well formed in the substrate SUB. The active region may form a P-type transistor together with gate lines GL.

According to an embodiment, a nanosheet, which is an active region, may be formed on each active region of the substrate SUB. A nanosheet stack NS formed of a plurality of nanosheets may be formed on the active region. The nanosheet stack NS may extend in the Y-axis direction. A device insulating layer 11 may be formed between the substrate SUB and the nanosheet stack NS.

The nanosheet stack NS may function as the channel of a transistor. For example, the nanosheet stack NS disposed on the active region of the substrate SUB may be doped with N-type impurities and may form a P-type transistor. According to an embodiment, the nanosheet stack NS may include Si, Ge, or SiGe. According to an embodiment, the nanosheet stack NS may include InGaAs, InAs, GaSb, InSb, or a combination thereof.

Each nanosheet stack NS may include a plurality of nanosheets NS1 through NS3 overlapping each other in a vertical direction (Z-axis direction). According to an embodiment, a case in which the nanosheet stack NS includes three nanosheets is exemplified, but embodiments are not limited to the illustrated case. For example, the nanosheet stack NS may include at least two nanosheets, and the number of nanosheets is not particularly limited.

The gate line GL may surround each of the plurality of nanosheets NS1 through NS3. The plurality of nanosheets NS1 through NS3 may have a GAA structure surrounded by the gate line GL. A gate insulating layer may be interposed between the nanosheet stack NS and the gate line GL.

Source/drain regions S/D (e.g., a first source/drain region and a second source/drain region) may be formed at both sides of the gate line GL, respectively, and thus, the source/drain regions S/D may be spaced apart from each other in the Y-axis direction.

Referring to FIG. 3A, one source/drain region S/D of the on-cell C_ON1 may be connected to the bit line BL formed in the first metal layer M1 through an active contact CA and a via VA of the first via layer V0. An interlayer insulating layer 12 may be formed on the active region. The active contact CA, which is a FS contact with the one source/drain region S/D, and the via VA may be formed through the interlayer insulating layer 12.

The other source/drain region S/D of the on-cell C_ON1 may be connected to the power line VSSL formed in the first backside metal layer BM1 through an active via BVA, which is a BS contact. According to an embodiment, the active via BVA may pass through the substrate SUB in the Z-axis direction, which is a vertical direction, and may have an upper surface in contact with the source/drain region S/D and a lower surface in contact with the power line VSSL.

However, as described above with reference to FIG. 2B, one source/drain region S/D of the on-cell C_ON2 may be connected to the power line VSSL formed in the first metal layer M1 through the active contact CA and the via VA of the first via layer V0, and the other source/drain region S/D of the on-cell C_ON1 may be connected to the bit line BL formed in the first backside metal layer BM1 through the active via BVA, which is a BS contact.

Referring to FIG. 3B, one source/drain region S/D of the on-cell C_ON1 may be connected to the bit line BL formed in the first metal layer M1 through the active contact CA and the via VA of the first via layer V0. The other source/drain region S/D of the on-cell C_ON1 may be connected to the power line VSSL formed in the first backside metal layer BM1 through a BS contact and the active via BVA, which are BS contacts. According to an embodiment, the active contact BCA may pass through the substrate SUB in the Z-axis direction, which is a vertical direction, and may have an upper surface in contact with the source/drain region S/D and a lower surface in contact with the active via BVA. The active via BVA may include an upper surface in contact with the active contact BCA and may include a lower surface in contact with the power line VSSL.

According to an embodiment, the active contact BCA may be formed in a trench etched in a direction from the upper surface of the substrate SUB to the lower surface of the substrate SUB (i.e., in a reverse direction to the Z-axis direction), and the active via BVA may be formed inside a trench etched in a direction (Z-axis direction) from the lower surface of the substrate SUB toward the upper surface of the substrate SUB. A width of the active contact BCA may gradually decrease in the reverse direction of the Z-axis direction, and a width of the active via BVA may gradually decrease in the Z-axis direction from the lower surface of the substrate SUB to the upper surface of the substrate SUB.

However, as described above with reference to FIG. 2B, one source/drain region S/D of the on-cell C_ON2 may be connected to the power line VSSL formed in the first metal layer M1 through the active contact CA and the via VA of the first via layer V0, and the other source/drain region S/D of the on-cell C_ON1 may be connected to the bit line BL formed in the first backside metal layer BM1 through the active contact BCA and the active via BVA, which are BS contacts.

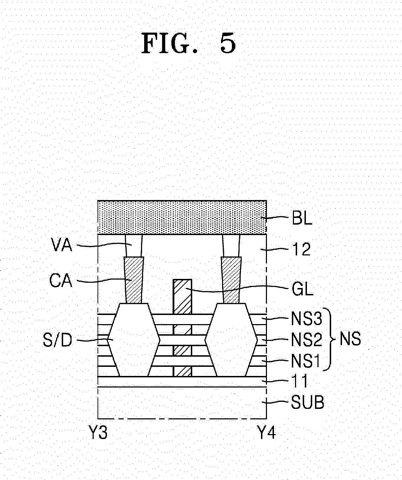

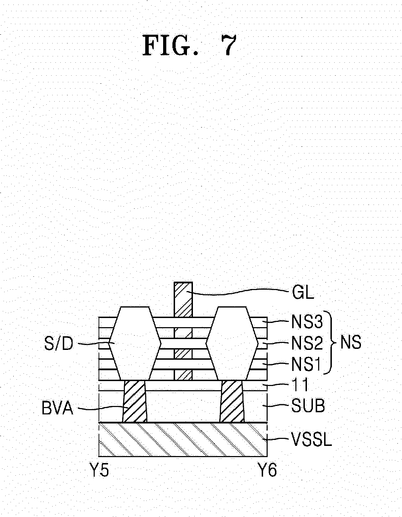

FIGS. 4 and 6 are layout views for explaining off-cells C_OFF1 and C_OFF2 among ROM cells included in an integrated circuit according to an embodiment. FIG. 5 is a cross-sectional view taken along line Y3-Y4 of FIG. 4, and FIG. 7 is a cross-sectional view taken along line Y5-Y6 of FIG. 6.

Referring to FIGS. 4 and 5, an off-cell C_OFF1 defined by a cell boundary may include a gate line and an active region that form a P-type transistor. The off-cell C_OFF1 may include an active contact CA and a via VA of the first via layer V0 connected to a bit line BL formed in a first metal layer M1.

Source/drain regions (i.e., a first source/drain and a second source/drain) of a transistor formed in the off-cell C_OFF1 may be both connected to a bit line BL. For example, the source/drain regions S/D included in the off-cell C_OFF1 may be both connected to the bit line BL through the respective active contacts CA and vias VA of the first via layer V0, which are FS contacts. Alternatively, according to an embodiment, when the bit line BL is formed in a first backside metal layer BM1 instead of the first metal layer M1, the off cell C_OFF1 may be connected to the bit line BL through a BS contact.

Referring to FIGS. 6 and 7, an off-cell C_OFF2 defined by a cell boundary may include a gate line and an active region that form a P-type transistor. The off-cell C_OFF2 may include an active via BVA, which is a BS contact, connected to a power line VSSL formed in a first backside metal layer BM1.

Both source/drain regions of a transistor formed in the off-cell C_OFF2 may be connected to the power line VSSL. For example, the source/drain regions S/D included in the off-cell C_OFF1 may be both connected to the power line VSSL through the respective active vias BVA, each of which is a BS contact. Alternatively, unlike what is shown in FIG. 7, the source/drain regions S/D included in the off-cell C_OFF2 may be both connected to the power line VSSL through respective active contacts (e.g., BCA of FIG. 3B), each of which is a BS contact, and respective active vias BVA formed under the active contacts BCA, respectively. Alternatively, according to an embodiment, when the power line VSSL is formed in the first metal layer M1 instead of the first backside metal layer BM1, the off cell C_OFF2 may be connected to the power line VSSL through an FS contact.

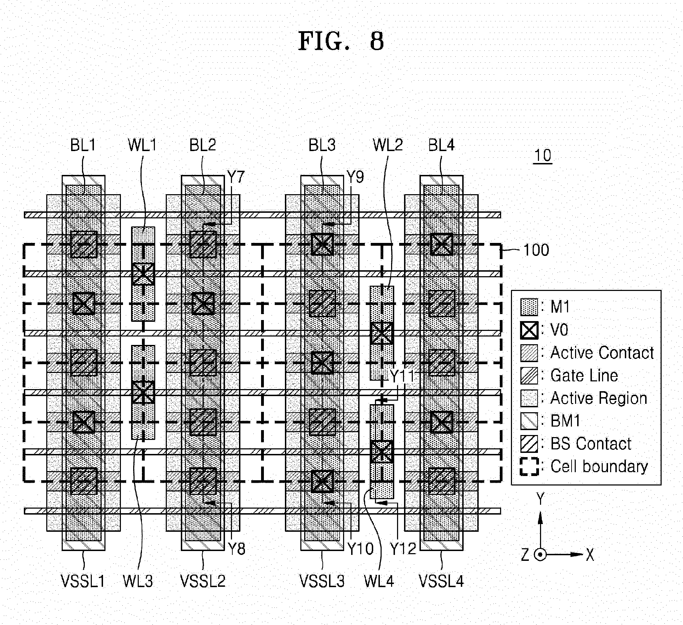

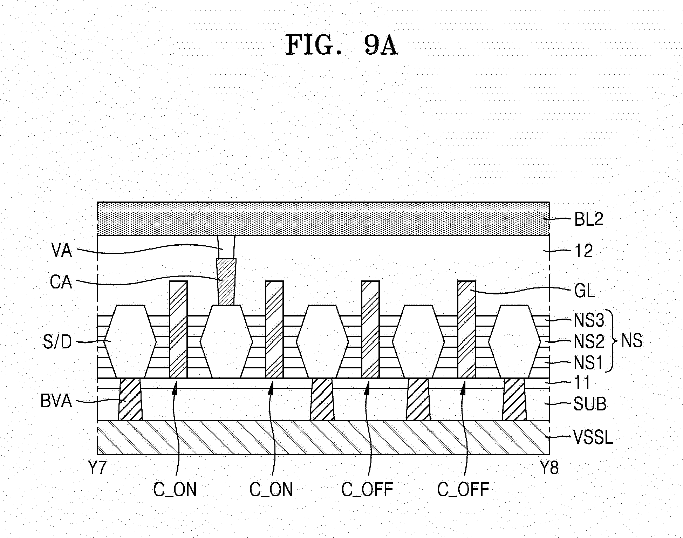

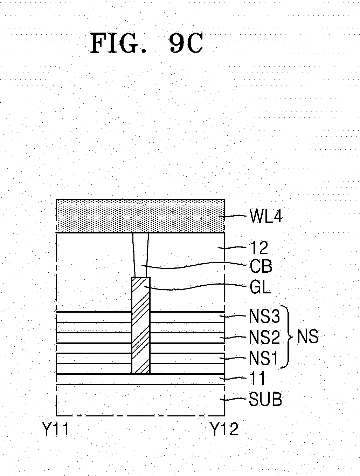

FIG. 8 is a view for explaining an integrated circuit 10 according to an embodiment. FIGS. 9A through 9C are cross-sectional views taken along lines Y7-Y8, Y9-Y10, and Y11-Y12 of FIG. 8, respectively.

Referring to FIGS. 8 and 9A through 9C, the integrated circuit 10 constituting one chip or one functional block may include a plurality of standard cells. A standard cell, which is a unit of a cell layout or a cell architecture included in an integrated circuit, may be defined by a cell boundary. The standard cell may be designed to perform a predefined function, and may be referred to as a cell or a semiconductor cell. The integrated circuit 10 may include a plurality of various standard cells.

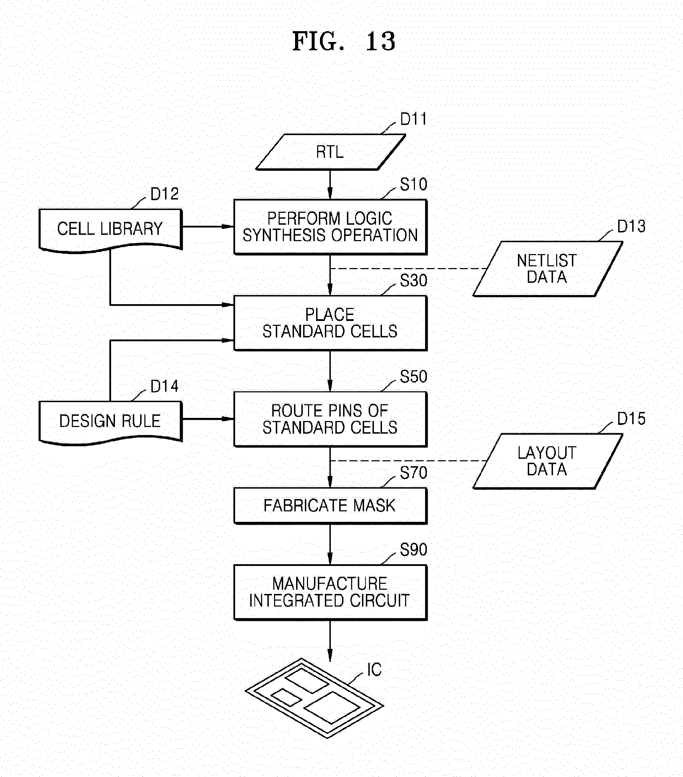

The plurality of standard cells may be used repeatedly in an integrated circuit design. The standard cells may be pre-designed according to manufacturing technology and stored in the cell library (e.g., D12 in FIG. 13), and standard cells stored in the standard cell library D12 may be arranged and connected to one another according to a design rule to thereby design the integrated circuit.

For example, the standard cells may include memory cells in which memory is implemented and may include a ROM cell in which ROM is implemented. Alternatively, for example, the standard cells may include various basic circuits (such as, an inverter, an AND gate, a NAND gate, an OR gate, an XOR gate, and a NOR gate) often used in a digital circuit design for electronic devices, such as central processing unit (CPU), graphics processing unit (GPU), and system-on-a-chip (SOC) designs. Alternatively, for example, the standard cells may include other circuits often used in a circuit block, such as a flip-flop and a latch.

The integrated circuit 10 may include a plurality of active regions and a plurality of gate lines. An active region and a gate line may form a transistor. Each of the plurality of gate lines formed in the integrated circuit 10 may extend in the X-axis direction, and each of the plurality of active regions may extend in the Y-axis direction.

According to an embodiment, the gate line may include a work function metal-containing layer and a gap-fill metal layer. For example, the work function metal-containing layer may include at least one metal among Ti, W, Ru, Nb, Mo, Hf, Ni, Co, Pt, Yb, Tb, Dy, Er, and Pd, and the gap-fill metal layer may be implemented using a W layer or an Al layer. According to an embodiment, the gate line may include a stack structure of TiAlC/TiN/W, a stack structure of TiN/TaN/TiAlC/TiN/W, or a stack structure of TiN/TaN/TiN/TiAlC/TiN/W.

The integrated circuit 10 may include a plurality of ROM cells 100 defined by cell boundaries. The plurality of ROM cells 100 may be arranged in a plurality of columns and a plurality of rows and constitute a memory cell array.

The integrated circuit 10 may include a plurality of word lines WL1 through WL4 providing word line signals to the plurality of ROM cells 100 and a plurality of bit lines BL1 through BL4 providing bit line signals to the plurality of ROM cells 100. According to an embodiment, the plurality of word lines WL1 through WL4 may be formed as a pattern of the first metal layer M1, and the plurality of bit lines BL1 through BL4 may also be formed as a pattern of the first metal layer M1. Each of the plurality of word lines WL1 through WL4 may be arranged between two different bit lines, for example, between a first bit line BL1 and a second bit line BL2 or between a third bit line BL3 and a fourth bit lines BL4.

Because the gate lines each extend in the X-axis direction, the ROM cells 100 arranged side by side in the X-axis direction may receive the same word line signals. Two specific ROM cells 100 arranged adjacently in the X-axis direction among the plurality of ROM cells 100 may share a gate via CB of the first via layer V0 connecting one word line (e.g., one of WL1 through WL4) to a gate line.

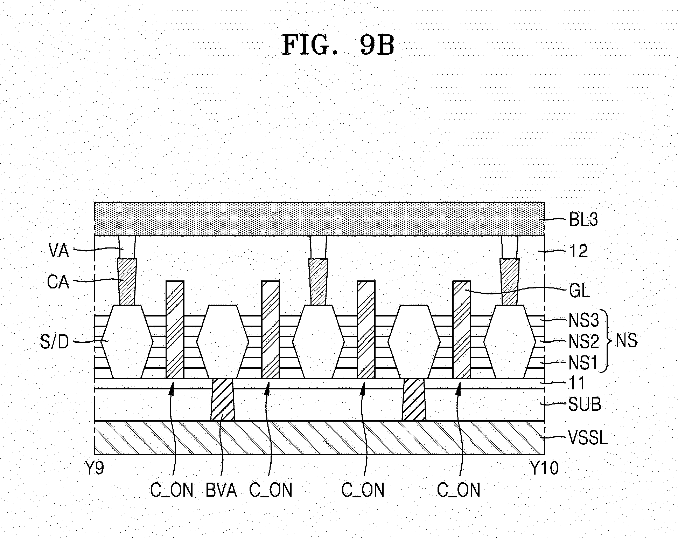

Because the gate regions each extend in the Y-axis direction, the ROM cells 100 arranged side by side in the Y-axis direction may receive the same bit line signals. Two ROM cells 100 arranged adjacently in the Y-axis direction may share one bit line (e.g., one of BL1 through BL4), the active contact CA connected to a source/drain region SD, and the active via VA of the first via layer V0. For example, as shown in FIGS. 9A and 9B, on-cells C_ON disposed adjacent to each other in the Y-axis direction may share the active contact CA and the active via VA of the first via layer V0.

The integrated circuit 10 may include a plurality of power lines VSSL1 through VSSL4 for supplying a power supply voltage (e.g., a ground voltage or VSS) to the plurality of ROM cells 100. The plurality of power lines VSSL1 through VSSL4 may each extend in the Y-axis direction, and may be formed as a pattern of the first backside metal layer BM1. Two ROM cells 100 arranged adjacently in the Y-axis direction may share the active via BVA, which is a BS contact, connecting one power line (e.g., one of VSSL1 through VSSL4) to a source/drain region SD. For example, as shown in FIGS. 9A and 9B, on-cells C_ON disposed adjacent to each other in the Y-axis direction may share the active via BVA. For example, as shown in FIG. 9A, ROM cells 100, which are disposed adjacent to each other in the Y-axis direction and are off-cells C_OFF, may share the active via BVA. For example, as shown in FIG. 9A, off-cells C_OFF disposed adjacent to each other in the Y-axis direction may share the active vias BVA, and an on-cell C_ON and an off-cell C_OFF disposed adjacent to each other in the Y-axis direction may share the active via BVA. However, unlike FIG. 9A, the off cell C_OFF may be formed like the off cell C_OFF1 described above with reference to FIG. 5, and the off cell C_OFF may be share the active contact CA and the active via VA of the first via layer V0, together with an ON cell C_ON disposed adjacent to the off cell C_OFF in the Y-axis direction.

The plurality of word lines WL1 through WL4 and the plurality of power lines VSSL1 through VSSL4 may be arranged to pass through respective centers of the plurality of ROM cells 100. According to an embodiment, the plurality of bit lines BL1 through BL4 and the plurality of power lines VSSL1 through VSSL4 of the integrated circuit 10 may be aligned with each other in the Z-axis direction. Accordingly, active vias VAs for connecting the plurality of ROM cells 100 to the plurality of bit lines BL1 through BL4, and active vias BVAs for connecting the plurality of ROM cells 100 to the plurality of power lines VSSL1 through VSSL4 may be arranged side by side with each other in the Y-axis direction in the plan view of FIG. 8. According to an embodiment, the active vias VAs and the active vias BVAs may be alternately arranged in the Y-axis direction in the plan view of FIG. 8.

Therefore, compared to a comparative example in which the plurality of bit lines BL1 through BL4 and the plurality of power lines VSSL1 through VSSL4 are all formed in a frontside metal layer, the integrated circuit 10 according to the disclosure provides a plurality of ROM cells that occupy a reduced area. Accordingly, an integration density of the integrated circuit 10 may be increased and the area of the integrated circuit 10 may be reduced. Because the plurality of power lines VSSL1 through VSSL4 are formed as a backside wiring pattern of the first backside metal layer BM1, the plurality of ROM cells 100 directly receive a power supply voltage through the backside wiring pattern, and thus, voltage drop characteristics of the power supply voltage provided to each of the ROM cells 100 may be improved.

In addition, in the integrated circuit 10 according to the embodiments, because the plurality of bit lines BL1 through BL4 and the plurality of power lines VSSL1 through VSSL4 are aligned in the Z-axis direction, limitations on a width of each of the plurality of ROM cells 100 in the X-axis direction may be reduced, so that the width of the ROM cell 100 in the X-axis direction may be adjusted. Accordingly, a width of the active region of a ROM cell 100 in the X-axis direction may be adjusted and the size of the P-type transistor constituting the ROM cell 100 may be adjusted. In addition, respective widths of the plurality of bit lines BL1 through BL4 connected to the plurality of ROM cells 100 in the X-axis direction may be adjusted.

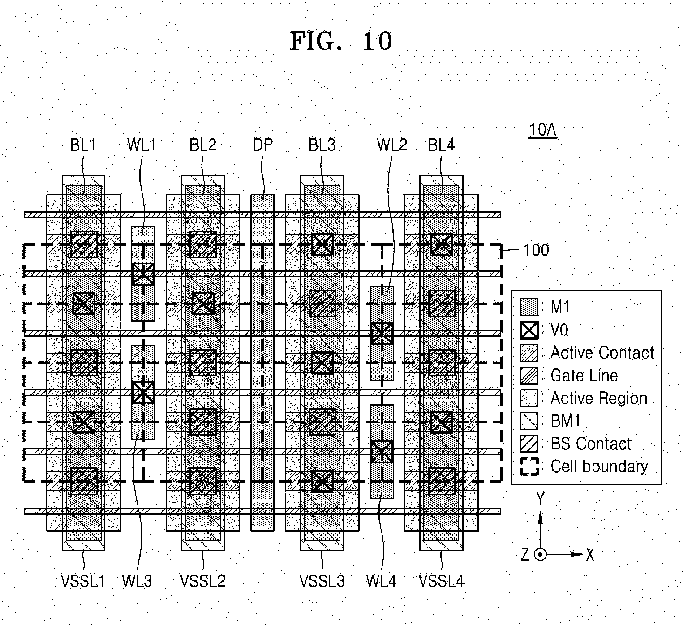

FIG. 10 is a view for explaining an integrated circuit 10A according to an embodiment. In a description of FIG. 10, duplicate descriptions of the same reference numerals as in FIG. 8 will be omitted.

Referring to FIG. 10, the integrated circuit 10A may include a plurality of word lines WL1 through WL4 providing word line signals to the plurality of ROM cells 100 and a plurality of bit lines BL1 through BL4 providing bit line signals to the plurality of ROM cells 100. According to an embodiment, the plurality of word lines WL1 through WL4 may be formed as a pattern of the first metal layer M1, and the plurality of bit lines BL1 through BL4 may also be formed as a pattern of the first metal layer M1.

The integrated circuit 10A may include a dummy pattern DP formed in the same layer as at least one of the plurality of word lines WL1 through WL4, the plurality of bit lines BL1 through BL4, and the plurality of power lines VSSL1 through VSSL4. According to an embodiment, the integrated circuit 10A may include a dummy pattern DP disposed in an area of the first metal layer M1 on which the plurality of word lines WL1 through WL4 and the plurality of bit lines BL1 through BL4 are not formed. For example, the dummy pattern DP may be formed in the first metal layer M1 and may extend in the Y-axis direction. For example, the dummy pattern DP may be disposed between the second bit line BL2 and the third bit line BL3 formed in the first metal layer M1.

According to an embodiment, the dummy pattern DP may be electrically separated from other metal layers disposed thereon and may be electrically separated from the plurality of ROM cells 100 disposed therebelow. For example, the dummy pattern DP may be disposed above the plurality of ROM cells 100 in the Y-axis direction and may be electrically separated from the plurality of ROM cells 100.

Because the integrated circuit 10A includes the dummy pattern DP, patterns having a constant pitch may be formed in the first metal layer M1 when the integrated circuit 10A is manufactured. Accordingly, when the integrated circuit 10A is manufactured, patterns of the first metal layer M1 may be stably formed to correspond to designed conditions.

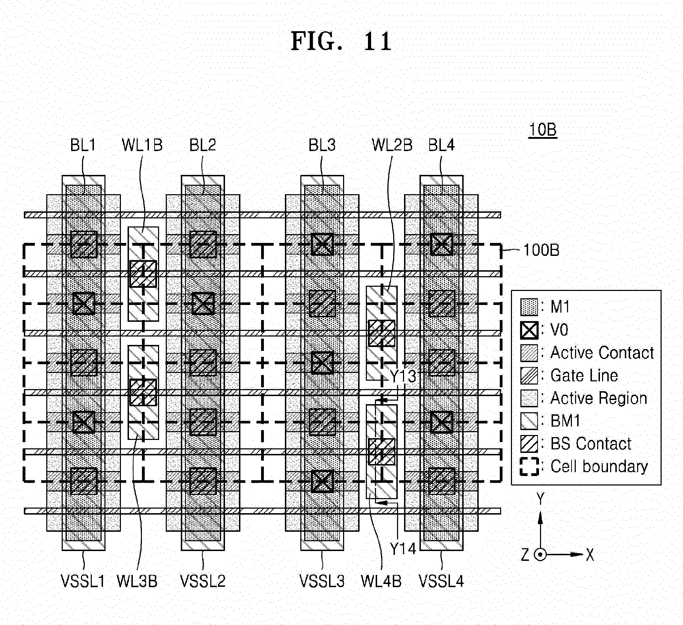

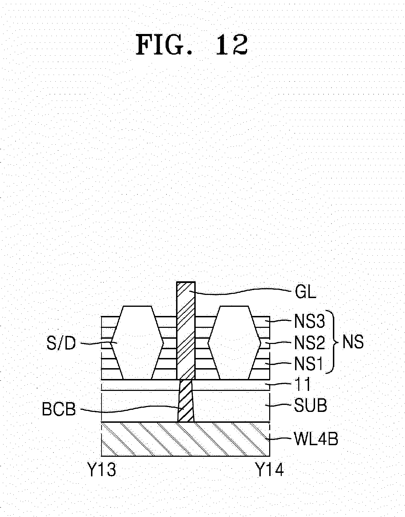

FIG. 11 is a view for explaining an integrated circuit 10B according to an embodiment. FIG. 12 is a cross-sectional view taken along line Y13-Y14 of FIG. 11. In a description of FIG. 11, duplicate descriptions of the same reference numerals as in FIG. 8 will be omitted.

Referring to FIGS. 11 and 12, the integrated circuit 10B may include a plurality of ROM cells 100B defined by cell boundaries. The plurality of ROM cells 100B may be arranged in a plurality of columns and a plurality of rows and constitute a memory cell array.

The integrated circuit 10B may include a plurality of word lines WL1B through WL4B providing word line signals to the plurality of ROM cells 100B and a plurality of bit lines BL1 through BL4 providing bit line signals to the plurality of ROM cells 100B. According to an embodiment, the plurality of word lines WL1B through WL4B may be formed as a pattern of the first backside metal layer BM1. Each of the plurality of word lines WL1 through WL4 may be arranged between two different power lines, for example, between a first power line VSSL1 and a second power line VSSL2 or between a third power line VSSL3 and a fourth power lines VSSL4.

Because the gate lines each extend in the X-axis direction, the ROM cells 100B arranged side by side in the X-axis direction may receive the same word line signals. Two ROM cells 100B arranged adjacently in the X-axis direction may be connected to a gate contact BCB, which is a BS contact, connecting one word line (e.g., one of WL1B through WL4B) to a gate line. The gate contact BCB may include an upper surface in contact with the gate line GL and a lower surface in contact with a word line (e.g., WL4).

According to an embodiment, the gate contact BCB may be formed inside a trench etched in a direction (Z-axis direction) from the lower surface of the substrate SUB toward the upper surface of the substrate SUB. The gate contact BCB may have a width that gradually decreases in a direction from the lower surface of the substrate SUB toward the upper surface of the substrate SUB.

In the integrated circuits 10, 10A, and 10B described above with reference to FIGS. 8, 10, and 11, the plurality of bit lines BL1 through BL4 formed in the first metal layer M1 and the plurality of power lines VSSL1 through VSSL4 formed in the first backside metal layer BM1 are disposed, but the integrated circuits 10, 10A, and 10B according to the disclosure are not limited thereto. In the integrated circuits 10, 10A, and 10B, the plurality of bit lines BL1 through BL4 and the plurality of power lines VSSL1 through VSSL4 may overlap each other in the Z-axis direction, the plurality of power lines VSSL1 through VSSL4 may be formed in the first metal layer M1, and the plurality of bit lines BL1 through BL4 may be formed in the first backside metal layer BM1. In other words, unlike the descriptions of FIGS. 8, 10, and 11, a position of the plurality of bit lines BL1 through BL4 and a position of the plurality of power lines VSSL1 through VSSL4 may be switched.

In the embodiments herein, the active via BVA, the active contact BCA, and the gate contact BCB are described as being formed in respective trenches or holes in the substrate SUB. However, the disclosure is not limited thereto. According to embodiments, the substrate SUB may be entirely or partially removed and replaced by a backside isolation structure or a backside insulation layer, similar to the interlayer insulation layer 12, which may isolate or insulation these BS contacts from another BS contact.

FIG. 13 is a flowchart of a method of manufacturing an integrated circuit IC, according to an embodiment. In detail, the flowchart of FIG. 13 illustrates an example of a method of manufacturing the integrated circuit IC including standard cells. As shown in FIG. 13, the method of manufacturing the integrated circuit IC may include a plurality of operations S10, S30, S50, S70, and S90. The integrated circuit IC may be any one of the integrated circuits 10, 10A, and 10B described above with reference to FIGS. 8, 10, and 11.

A cell library (or a standard cell library) D12 may include information about standard cells, for example, information about functions, characteristics, a layout, and the like of the standard cells. According to an embodiment, the cell library D12 may define tap cells and dummy cells as well as memory cells including ROM cells and function cells generating output signals from input signals.

A design rule D14 may include requirements that a cell layout of the integrated circuit IC must comply with. For example, the design rule D14 may include requirements for a space between patterns in the same layer, the minimum width of a pattern, a routing direction of a metal layer, and the like.

In operation S10, a logic synthesis operation may be performed to generate netlist data D13 from RTL data D11. For example, a semiconductor design tool (for example, a logic synthesis tool) may perform a logic synthesis with reference to the standard cell library D12 from the RTL data D11 written in a Hardware Description Language (HDL) such as VHSIC Hardware Description Language (VHDL) and Verilog, and may generate netlist data D13 including a bitstream or a netlist. The netlist data D13 may correspond to an input of placing and routing which will be described later.

In operation S30, a plurality of standard cells required to form the integrated circuit may be selected and placed. For example, a semiconductor design tool (for example, a P&R tool) may place standard cells used by the netlist data D13, by referring to the cell library D12. According to an embodiment, the semiconductor design tool may place a plurality of ROM cells in a plurality of rows and a plurality of columns. For example, in operation S30, the ROM cells C_ON1, C_ON2, C_OFF1, C_OFF2, C_ON, C_OFF, and 100 described above with reference to FIGS. 1 through 12 may be placed.

In operation S50, pins of the standard cells may be routed. For example, the semiconductor design tool may generate interconnections electrically connecting output pins and input pins of the placed standard cells to each other and may generate layout data D15 defining the placed standard cells and the generated interconnections. An interconnection may include one or more via(s) in a via layer and/or patterns of metal layers. The metal layers may include not only frontside metal layers positioned on a gate line, such as the first metal layer (e.g., M1 in FIG. 8 ), but also a backside metal layer positioned below he gate line, such as the first backside metal layer (e.g., BM1 in FIG. 8). The layout data D15 may have a format such as GDSII and may include geometric information about the standard cells and geometric information about the interconnections. The semiconductor design tool may refer to the design rule D14 while routing the pins of the standard cells. According to an embodiment, the dummy pattern DP of FIG. 10 may be disposed in operation S50, which is a routing operation.

The layout data D 15 may correspond to an output of the placing and routing. Operation S50 alone, or operations S30 and S50 collectively, may be referred to as a method of designing an integrated circuit.

In operation S70, a mask may be fabricated. For example, optical proximity correction (OPC) for correcting a distortion phenomenon such as refraction caused due to the characteristics of light in photolithography may be applied to the layout data D15. Patterns on the mask may be defined to form patterns formed in a plurality of layers according to OPC-applied data, and at least one mask (or photomask) for forming respective patterns of the plurality of layers may be fabricated. According to an embodiment, the layout of the integrated circuit IC may be limitedly modified in operation S70, and the limited modification of the integrated circuit IC in operation S70 is a post-processing for optimizing the structure of the integrated circuit IC, and may be referred to as design polishing.

In operation S90, the integrated circuit IC may be manufactured. For example, the integrated circuit IC may be manufactured by patterning the plurality of layers by using the at least one mask fabricated in operation S70. The front-end-of-line (FEOL) may include, for example, an operation of planarizing and cleaning a wafer, an operation of forming a trench, an operation of forming a well, an operation of forming a gate electrode, and an operation of forming a source/drain region. Individual devices, such as a transistor, a capacitor, a resistor, and the like, may be formed on a substrate by the FEOL. The back-end-of-line (BEOL) may include, for example, an operation of silicidating a gate region, a source/drain region, an operation of adding a dielectric, a planarization operation, an operation of forming a hole, an operation of adding a metal layer, an operation of forming a via, and an operation of forming a passivation layer. Individual devices, such as a transistor, a capacitor, a resistor, and the like, may be interconnected to each other by the BEOL. According to some embodiments, the middle-of-line (MOL) may be performed between the FEOL and the BEOL, and contacts may be formed on individual devices. Next, the integrated circuit IC may be packaged into a semiconductor package and may be used as a component part of various applications.

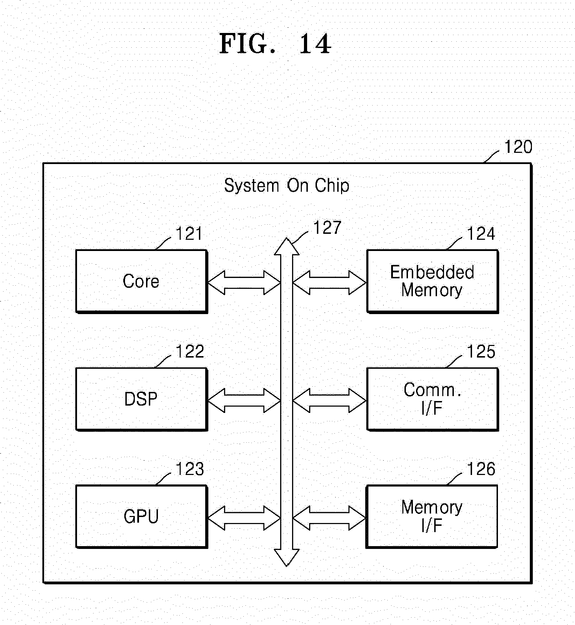

FIG. 14 is a block diagram of a system on chip (SoC) 120 formed including at least one of the ROM cells of FIGS. 2A, 2B, 4 and 6, and the integrated circuits of FIGS. 8, 10 and 11, according to an embodiment. The SoC 120 may refer to as an integrated circuit in which components of a computing system or other electronic systems are integrated. For example, an application processor (AP) as an example of the SoC 120 may include component parts for a processor and other functions. As shown in FIG. 14, the SoC 120 may include a core 121, a digital signal processor (DSP) 122, a GPU 123, an internal memory 124, a communication interface 125, and a memory interface 126. The components of the SoC 120 may communicate with each other via a bus 127. At least one of these components of the SoC 120 may include at least one of the ROM cells of FIGS. 2A, 2B, 4 and 6, and the integrated circuits of FIGS. 8, 10 and 11, according to embodiments.

The core 121 may process instructions and may control operations of the components included in the SoC 120. For example, the core 121 may drive an operating system and execute applications on the operating system, by processing a series of instructions. The DSP 122 may generate useful data by processing a digital signal, e.g., a digital signal provided by the network interface 125. The GPU 123 may generate data for an image output on a display device from image data provided by the internal memory 124 or the memory interface 126, and may encode image data. The internal memory 124 may store data necessary for operations of the core 121, the DSP 122, and the GPU 123.

The network interface 125 may provide an interface for a communication network or one-to-one communication. The memory interface 126 may provide an interface for an external memory of the SoC 120, such as dynamic random access memory (DRAM) or flash memory.

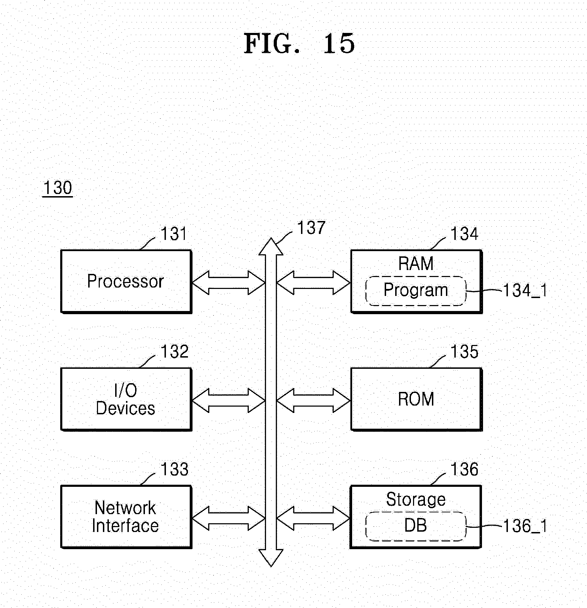

FIG. 15 is a block diagram of a computing system 130 including a memory that stores a program, according to an embodiment. At least some of the operations included in a method of designing an integrated circuit according to an embodiment, for example, the operations of the above-described flowchart, may be performed in the computing system (or a computer) 130.

The computing system 130 may be a stationary computing system, such as a desktop computer, a workstation, or a server, or may be a mobile computing system, such as a laptop computer. Referring to FIG. 15, the computing system 130 may include a processor 131, input/output (I/O) devices 132, a network interface 133, random access memory (RAM) 134, read only memory (ROM) 135, and a storage 136. The processor 131, the I/O devices 132, the network interface 133, the RAM 134, the ROM 135, and the storage 136 may be coupled with each other via a bus 137 and may communicate with each other via the bus 137.

The processor 131 may be referred to as a processing unit and may include at least one core capable of executing any instruction set (e.g., Intel Architecture-32 (IA-32), 64-bit extension IA-32, x86-64, PowerPC, Sparc, MIPS, ARM, and IA-64), like a microprocessor, an application processor (AP), a digital signal processor (DSP), or a GPU. For example, the processor 131 may access a memory, namely, the RAM 134 or the ROM 135, via the bus 137 and may execute the instructions stored in the RAM 134 or the ROM 135.

The RAM 134 may store a program 134_1 for a method of designing an integrated circuit according to an embodiment or at least a portion of the program 134_1, and the program 134_1 may enable the processor 131 to perform at least some of the operations included in the method of designing the integrated circuit, for example, the method of FIG. 13. In other words, the program 134_1 may include a plurality of instructions executable by the processor 131, and the plurality of instructions included in the program 134_1 may enable the processor 131 to perform, for example, at least some of the operations included in the above-described flowcharts.

The storage 136 may not lose stored data even if power supplied to the computing system 130 is cut off. For example, the storage 136 may include a non-volatile memory, or may include a storage medium, such as magnetic tape, an optical disk, a magnetic disk. The storage 136 may be detachable from the computing system 130. The storage 136 may store the program 134_1 according to an embodiment, and the program 134_1 or at least a portion thereof from the storage 136 may be loaded into the RAM 134 before the program 134_1 is executed by the processor 131. Alternatively, the storage 136 may store a file written in a programming language, and a program 134_1 generated by a compiler or the like or at least a portion of the program 134_1 from the file may be loaded into the RAM 134. As shown in FIG. 15, the storage 136 may store a database (DB) 136_1, and the DB 136_1 may include information necessary for designing the integrated circuit, for example, information about designed blocks, the cell library D12 and/or the design rule D14 of FIG. 13.

The storage 136 may store data that is to be processed by the processor 131, or data processed by the processor 131. In other words, according to the program 134_1, the processor 131 may generate data by processing the data stored in the storage 136, and may store the generated data in the storage 136. For example, the storage 136 may store the RTL data D 1, the netlist data D13, and/or the layout data D15 of FIG. 13.

The I/O devices 132 may include an input device, such as a keyboard or a pointing device, and an output device, such as a printer or a display. For example, a user may trigger the execution of the program 134_1 by the processor 131 via the I/O devices 132, may input the RTL data D 11 and/or the netlist data D13 of FIG. 13, and may check the layout data D15 of FIG. 13.

The network interface 133 may provide access to a network outside the computing system 130. For example, the network may include multiple computing systems and communication links, and the communication links may include wired links, optical links, wireless links, or any other type of links.

While the disclosure has been particularly shown and described with reference to embodiments thereof, it will be understood that various changes in form and details may be made therein without departing from the spirit and scope of the following claims.

## Claims

1. An integrated circuit comprising a read only memory (ROM) cell which comprises an on-cell,
wherein the on-cell comprises:
a first source/drain region and a second source/drain region;
a frontside contact between the first source/drain region and a bit line on a front side of the on-cell; and
a backside contact between the second source/drain region and a power line on a back side of the on-cell,
wherein the bit line is configured to provide a bit line signal to the on-cell,
wherein the power line is configured to provide a power supply voltage signal to the on-cell, and
wherein the bit line and the power line are vertically aligned with each other.

2. The integrated circuit of claim 1, wherein the on-cell further comprises a gate line extending in a first horizontal direction.

3. The integrated circuit of claim 2, wherein the bit line and the power line are extended in a second horizontal direction perpendicular to the first horizontal direction.

4. The integrated circuit of claim 1, wherein the frontside contact comprises:
an active contact on the first source/drain region; and
an active via between the active contact and the bit line.

5. The integrated circuit of claim 1, wherein the backside contact comprises an active via on the second source/drain region and the power line.

6. The integrated circuit of claim 1, wherein the backside contact comprises:
an active contact on the second source/drain region; and
an active via between the active contact and the power line.

7. The integrated circuit of claim 1, wherein the ROM cell comprises an off-cell which comprises:
a third source/drain region and a fourth source/drain region;
a frontside contact between the bit line and the third source/drain region; and
a frontside contact between the bit line and the fourth source/drain region.

8. The integrated circuit of claim 1, wherein the ROM cell comprises an off-cell which comprises:
a third source/drain region and a fourth source/drain region;
a backside contact between the power line and the third source/drain region; and
a backside contact between the power line and the fourth source/drain region.

9. An integrated circuit comprising:
a plurality of read only memory (ROM) cells;
a plurality of bit lines configured to provide bit line signals to the plurality of ROM cells;
a plurality of word lines configured to provide word line signals to the plurality of ROM cells; and
a plurality of power lines configured to provide a power supply voltage to the plurality of ROM cells,
wherein the plurality of bit lines and the plurality of power lines are aligned with each other in a vertical direction.

10. The integrated circuit of claim 9, wherein the plurality of bit lines are in a metal layer on a front side of the plurality of ROM cells, and
wherein the plurality of power lines are in a metal layer on a back side of the plurality of ROM cells.

11. The integrated circuit of claim 9, wherein the plurality of bit lines are in a metal layer on a back side of the plurality of ROM cells, and
wherein the plurality of power lines are in a metal layer on a front side of the plurality of ROM cells.

12. The integrated circuit of claim 9, wherein the plurality of word lines are in a metal layer on a front side of the plurality of ROM cells.

13. The integrated circuit of claim 9, wherein the plurality of word lines are in a metal layer on a back side of the plurality of ROM cells.

14. The integrated circuit of claim 9, further comprising:
a first via electrically connecting the plurality of bit lines to the plurality of ROM cells; and
a second via electrically connecting the plurality of power lines to the plurality of ROM cells,
wherein the plurality of bit lines and the plurality of power lines each extend in a first horizontal direction, and
wherein the first via and the second via are disposed side by side in the first horizontal direction.

15. An integrated circuit comprising a read only memory (ROM) cell comprising an on-cell which comprises:
a first source/drain region and a second source/drain region;
a backside contact between a bit line in a backside metal layer on a back side of the ROM cell and the first source/drain region; and
a frontside contact between a power line in a metal layer on a front side of the ROM cell and the second source/drain region,
wherein the bit line is configured to provide a bit line signal to the on-cell,
wherein the power line is configured to provide a power supply voltage signal to the on-cell, and
wherein the bit line and the power line are aligned with each other in a vertical direction.
